Europäisches Patentamt

European Patent Office

Office européen des brevets

(11) Publication number: 0 405 758 A2

# EUROPEAN PATENT APPLICATION

(21) Application number: 90305904.6

(22) Date of filing: 31.05.90

(51) Int. Cl.5: H01S 3/18, H01S 3/00

(30) Priority: 27.06.89 US 371956

(43) Date of publication of application:
02.01.91 Bulletin 91/01

(84) Designated Contracting States:
DE FR GB IT NL

(71) Applicant: Hewlett-Packard Company
3000 Hanover Street
Palo Alto California 94304(US)

(72) Inventor: Kerps, Dietrich
P.O.Box 4546B10 Ee Camino Real
Los Altos CA 94022(US)

(74) Representative: Colgan, Stephen James et al
CARPMAELS & RANSFORD 43 Bloomsbury
Squareare
London WC1A 2RA(GB)

(54) Broadband semiconductor optical gain medium.

(57) The gain bandwidth of a semiconductor optical gain medium such as a semiconductor laser or an optical amplifier can be increased by reducing the effective band-gap energy (9), (22) or (24) between the conduction band (1) and the valence band (3) and by increasing the quasi-Fermi level separations (23), (25), and (27) during device operation. This is achieved by heavily n-doping the active layer of a III-V semiconductor optical gain medium or heavily p-doping the active layer of semiconductor optical gain medium fabricated from a material system having a conduction band with a high density of electron states and a valence band with a low density of hole states.

FIG 1

# A BROADBAND SEMICONDUCTOR OPTICAL GAIN MEDIUM

## Background of the Invention

The present invention relates to broadband semiconductor optical gain media and their application in semiconductor optical amplifiers and tunable semiconductor lasers.

As electrical communication systems are replaced by optical communication systems, optical amplifiers may become as prominent as their electrical counterparts. Since future optical communication systems probably will transmit signals at several different frequencies, a semiconductor optical amplifier providing gain over a broad frequency range is highly desirable. Of even greater value is a semiconductor laser having gain over a wide frequency range so that it is tunable over a wide range of frequencies. Such a tunable semiconductor laser can be used to implement optical homodyne and heterodyne detection schemes.

U.S. Patent 4,794,346, by Miller entitled Broadband Semiconductor Optical Amplifier Structure , discloses a broadband semiconductor optical amplifier having a two-stage active region. Each stage amplifies light signals from a different but adjacent portion of the frequency spectrum thereby providing a broad continuous frequency range. in contrast, a semiconductor optical gain medium, according to the preferred embodiment of the present invention, obtains its broad frequency range solely from the heavy n-doping of a single stage that is fabricated from inGaAsP material or from any III-V material system.

Generally, active regions of prior-art heterojunction III-V semiconductor lasers are eight p-doped or undoped. An exception to this rule is described by N. Tamari in "Tin Doping of Active Region in InGaAsP/InP Lasers", Applied Physics Letters , Vol. 40, No. 2, 15 January 1982. Tamari heavily n-doped the active region for the purpose of locating the p-n junction accurately and reproducibly in the presence of the p-dopant, Zn, which tends to misplace the location of the junction because of its fast diffusion characteristic. Tamari suggested limiting the doping of the active region to $4 \times 10^{18} cm^{-3}$ to avoid changing characteristics of the active region such as its threshold current density. In contrast, in the present invention, the active region is heavily n-doped specifically to change one of its characteristics--the gain bandwidth. Tamari does not disclose the effect of heavy n-doping on the band-gap potential or on the separation of the quasi-Fermi levels. Nor does Tamari suggest that heavy n-doping of the active region will increase the gain bandwidth.

## Summary of the Invention

The object of the invention is the amplification of optical signals over a wide range of frequencies.

The present invention is a semiconductor optical gain medium having an increased gain bandwidth that is produced by decreasing the effective band-gap energy between the conduction and valence bands and by increasing the separation between the quasi-Fermi levels of the conduction and valence bands through heavy doping of the gain medium. The band gap of a gain medium constructed from a III-V material system is decreased by band gap shrinkage caused by high free carrier concentration and by bandtailing due to heavy n-doping. This extends the low energy end of the gain range. The separation of the quasi-Fermi levels for a given injected carrier concentration increases when the III-V gain medium is heavily n-doped. This extends the high-energy end of the gain range of the operating device. If a material system is used that has a conduction band with a high density of electron states and a valence band with a low density of hole states, the opposite of a III-V material system, then the gain medium must be heaveily p-doped, instead of heavily n-doped, to reduce the band-gap potential and to increase the separation of the quasi-Fermi levels.

Applications of this invention include optical amplifiers and tunable semiconductor lasers. In optical amplifiers, the increased gain bandwidth results in a broadband amplifier. In tunable semiconductor lasers, the increased gain bandwidth gives the laser a much wider tuning range.

## Brief Description of the Drawings

Figure 1 is a plot of energy (on the ordinate) versus density of states in the conduction and valence bands (on the abscissa) for a semiconductor optical gain medium.

Figure 2A is a plot of gain and absorption (on the ordinate) versus photon energy (on the abscissa) for various values of the injection current.

Figure 2B is derived from Figure 2A and shows the gain range (on the abscissa) of an operating gain medium versus the injection current (on the ordinate).

Figure 3A shows theoretical values of gain bandwidth (full width at half maximum) (eV) on the ordinate versus nominal radiative recombination

current density (A/cm²μm) on the abscissa for a 1.3μm-wavelength InGaAsP semiconductor optical gain medium having various levels of n and p doping.

Figure 3B shows theoretical values of gain bandwidth (full width at half maximum) (eV) on the ordinate versus nominal total recombination current density (A/cm²μm) on the abscissa for a 1.3μm-wavelength InGaAsP semiconductor optical gain medium having various levels of n and p doping.

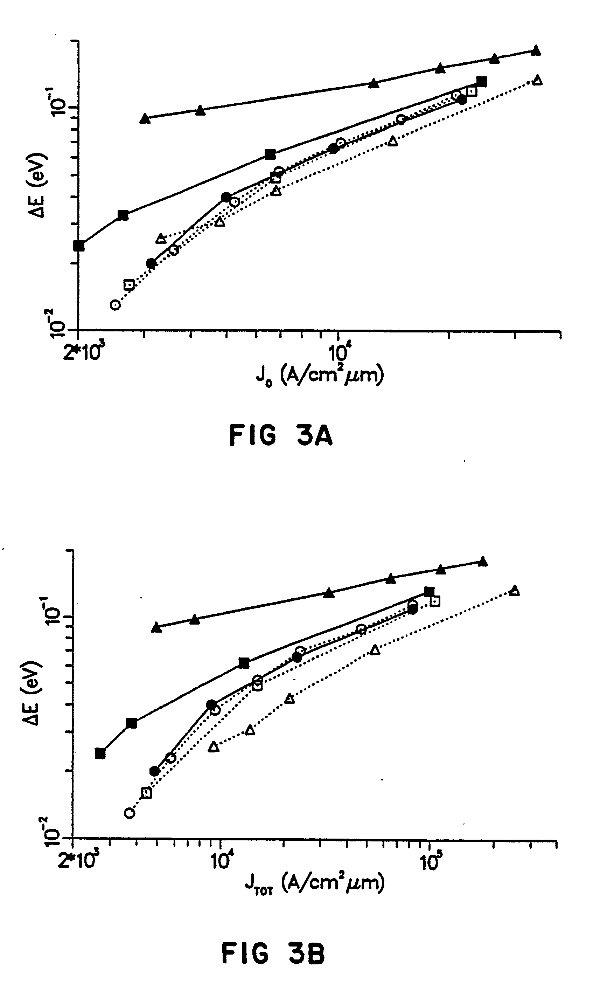

In Figures 3A and 3B the circular, square, and triangular symbols indicate doping concentration of $1\times10^{17}$ cm⁻³, $1\times10^{18}$ cm⁻³, and $5\times10^{18}$ cm⁻³ respectively. The open symbols represent p-doping and the solid symbols represents n-doping.

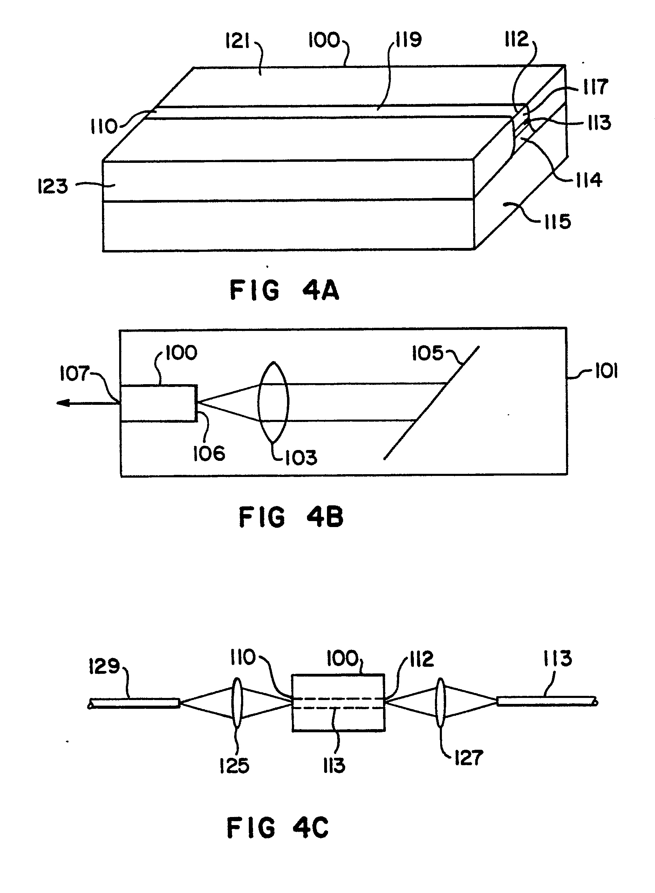

Figure 4A is a diagram of a semiconductor laser chip or an optical amplifier.

Figure 4B is a diagram of a tunable semiconductor laser consisting of the semiconductor laser chip of Figure 4A in a external cavity employing a grating.

Figure 4C is a diagram of an optical amplifier system employing the optical amplifier shown in Figure 4A in an optical transmission circuit.

Detailed Description of the Invention

To clearly point out and describe the invention, detail in the drawings and description is limited to that sufficient to enable one skilled in the art to understand the invention and build embodiments of it.

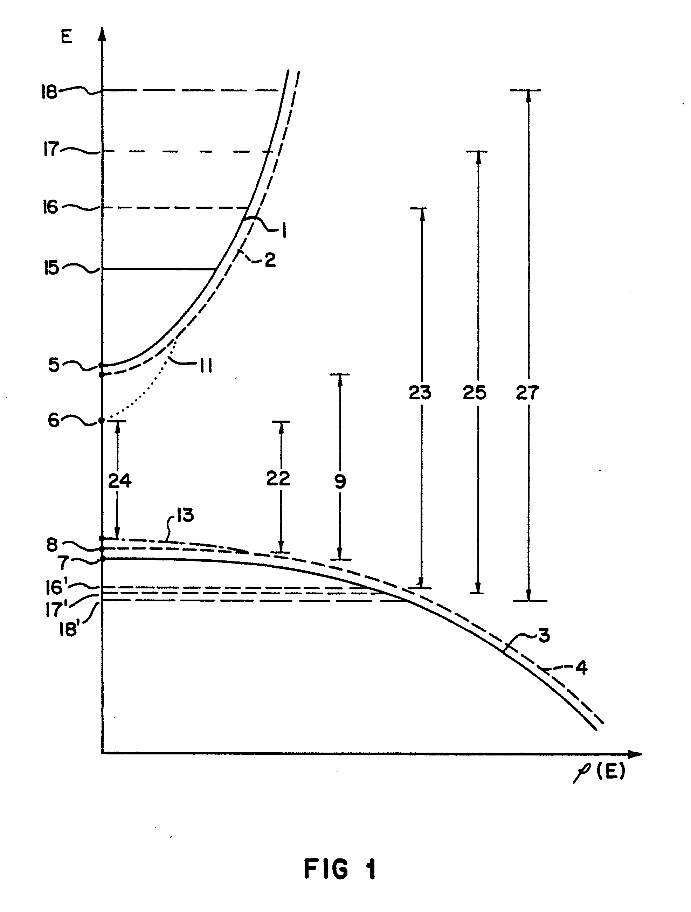

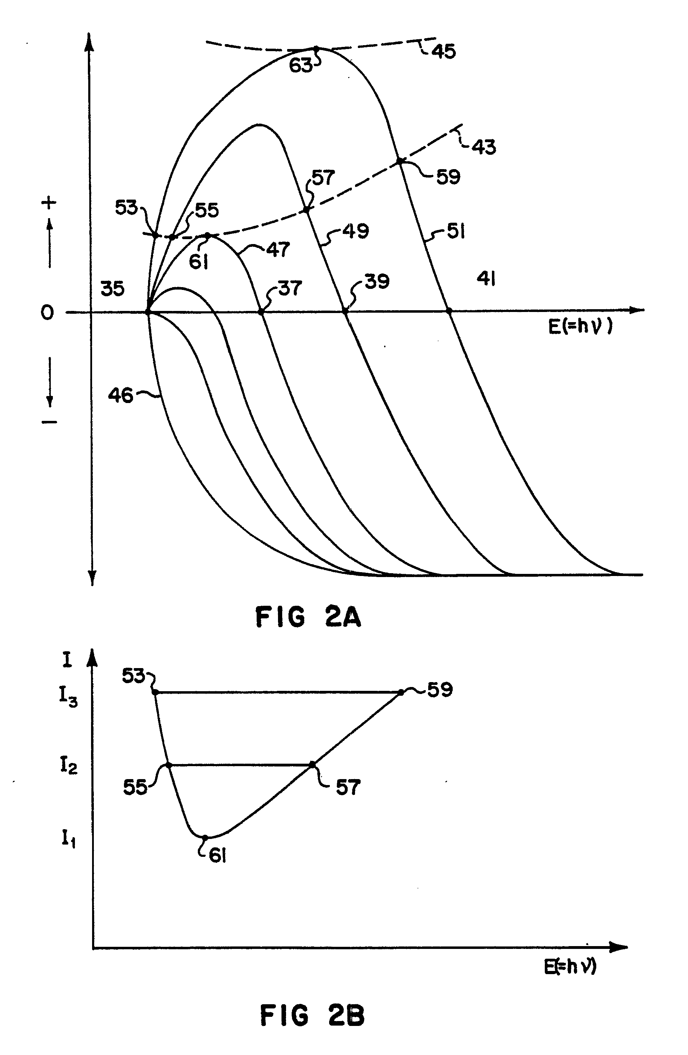

Heavy n-doping of a III-V semiconductor optical gain medium, the preferred embodiment of the invention, results in a reduction of the effective band-gap energy and in an increase in the separation of the quasi-Fermi levels as shown in Figure 1. These two effects, respectively, extend the high-energy and low-energy ends of the gain curves shown in Figure 2A. The net result is that the gain bandwidth, shown in Figure 2B, is increased.

Figure 1 is a plot of the energy of electrons in the conduction band (curves (1) and (2)) and energy of holes in the valence band (curves (3) and (4)) versus the density of states of electrons and holes in the active layer of a device such as an optical amplifier or a semiconductor laser chip. The solid curves, (1) and (3), represent the conduction band and valence band, respectively, for an undoped gain medium. The effective band-gap energy (9) of the undoped medium extends from the bottom of the conduction band (5) to the top of the valence band (7).

The dashed curves, (2) and (4), represent the conduction band and the valence bands, respectively, for a heavily n-doped gain medium that has a high injected carrier concentration. The reduction of the conduction-band energy indicated by the dotted curve (11) results from band tail states created by heavy n-doping. (For more information on how high doping creates band tails and how a high carrier concentration shrinks the band gap, see Chapter 3 of Heterostructure Lasers Part A: Fundamental Principles , H.C. Casey and M.B. Panish, New York: Academic Press, 1978.) The heavy n-doping has caused the effective band-gap energy to shrink from (9) to (22). The effective band-gap energy can be further reduced to (24) by p-doping of the active region which is allowed as long as the p-doping level is a fraction of the n-doping level. The dot-dash line (13) shows band tail states caused by high p-doping.

The top half of Figure 2A shows a family of gain curves which described the gain during operation of the device at different levels of injection current. The bottom half of Figure 2A shows the absorption curves of the gain medium at various injection currents. When the device is not operating, i.e., when the injection current equals zero, only absorption occurs as shown by the curve (46). The effective band-gap energy (22) of Figure 1 defines the low energy end of the gain and absorption curves (35), shown in Figure 2A, because there are no electron or hole states between the bottom of the conduction band (6) and the top of the valence band (8) shown in Figure 1. The absence of electron and hole states causes absorption and gain to be zero at energies less than the effective band-gap energy (22). Therefore, a reduction in the effective band-gap energy (22) moves the low energy end (35) of the gain and absorption curves, shown in Figure 2A, to the left and thus reduces the lower bound of the frequency range over which the medium exhibits gain.

Heavy n-doping of the active region extends the high energy ends of the gain curves shown in Figure 2A by increasing the quasi-Fermi level separations (23), (25) and (27) shown in Figure 1. The equilibrium Fermi level (15) moves higher in the conduction band with increased levels of n-doping because n-doping increases the number of equilibrium electrons in the conduction band. With increased levels of n-doping, the electron quasi-Fermi levels (16), (17), and (18) corresponding respectively to the injection currents $I_1$, $I_2$, and $I_3$ move higher in the conduction band and the corresponding hole quasi-Fermi levels (16'), (17'), and (18') move lower in the valence band because the density of electrons and holes increases above the equilibrium condition (15). The movement of the electron quasi-Fermi levels (16), (17), and (18) away from the hole quasi-Fermi levels (16'), (17'), and (18') increases the quasi-Fermi level separations (23), (25), and (27).

The high energy ends (upper frequency limits) (37), (39), and (41) of the gain curves (47), (49), and (51), respectively, shown in Figure 2A are equal to the quasi-Fermi level separations (23), (25), and (27) shown in Figure 1. The semiconductor gain medium exhibits gain when the separation of the quasi-Fermi levels exceeds the photon emission energy according to the equation $F_c - F_v > E = h\nu$, where $F_c$ is the potential of the electron quasi-Fermi level, $F_v$ is the potential of the hole quasi-Fermi level and $E = h\nu$ is the photon energy. (For additional explanation of this equation, see page 118 of Heterostructure Lasers Part A: Fundamental Principles, H.C. Casey and M.B. Panish, New York: Academic Press, 1978.)

Figure 3A shows theoretical values of gain bandwidth (full width at half maximum) (eV) on the ordinate versus nominal radiative recombination current density (A/cm²μm) on the abscissa for a 1.3μm-wavelength InGaAsP semiconductor optical gain medium having various levels on n and p doping. The nominal recombination current density is the current density required to excite a 1μm-thick active layer. The circular, square, and triangular symbols indicate doping concentrations of $1 \times 10^{17} cm^{-3}$, $1 \times 10^{18} cm^{-3}$, and $5 \times 10^{18} cm^{-3}$ respectively. The open symbols represent p-doping and the solid symbols represent n-doping. At a given current density, the gain bandwidth tends to increase with higher n-doping and decrease with higher p-doping.

Figure 3B shows theoretical values of gain bandwidth (full width at half maximum) (eV) on the ordinate versus nominal total recombination current density (A/cm²μm) on the abscissa for a 1.3μm-wavelength InGaAsP semiconductor optical gain medium having various levels of n and p doping. The total recombination current differs from the radiative recombination current in that it includes the effect of Auger recombination. Auger recombination occurs when the recombination energy of a recombining electron-hole pair is dissipated by exciting another carrier to a higher energy. For low-band-gap III-V compound the Auger recombination must be included in addition to the radiative recombination because the probability of this process occurring increases as the band gap of the gain medium decreases. Auger recombination is less prevalent in n-doped than in p-doped active layers because excitation of a hole into the splitoff valence band is the most favored process. (For further information on Auger recombination, see Robert Olshansky et al., "Measurement of Radiative and Non-Radiation Recombination Rates In InGaAsP and AlGaAs Light Source", IEEE Journal of Quantum Electronics, Vol. QE-20, pg. 838-854, 1984 and Albert hauf, "Theory of Temperature Dependence of the Threshold Current of a InGaAsp Laser", IEEE Journal of Quantum Electronics, Vol. QE-21, pg.716-718, 1985.) The circular, square, and triangular symbols in Figure 3B indicate doping concentrations of $1 \times 10^{17} cm^{-3}$, $1 \times 10^{18} cm^{-3}$, and $5 \times 10^{18} cm^{-3}$ respectively. The open symbols represent p-doping and the solid symbols represent n-doping. At a given current density, the gain bandwidth tends to increase with increased n-doping and decrease with increased p-doping. Because of the Auger effect, the increase in the bandwidth for high n-doping is more pronounced in Figure 3B than in Figure 3A. The method of the theoretical calculation used to generate the data in Figures 3A and 3B is described by Casey and Panish, supra, Chapter 3.

The embodiments of this invention provide a wide gain range for a semiconductor optical amplifier or semiconductor laser chip fabricated from any III-V material system or more specifically from InGaAsP operating in the 1.3μm to 1.5μm optical wavelength range. Heavy n-doping results in a large gain bandwidth because the density of states in the conduction band is much smaller than density of states in the valence band for all III-V materials. Conversely, if a material system having a low density of states in the valence band and a high density of states in the conduction band is used, then high p-doping of the gain medium would increase the gain bandwidth.

Applications of the present invention include the optical amplifier and the semiconductor laser chip shown in Figure 4A and as item (100) in Figures 4B and 4C. This particular structure is one example but other semiconductor laser or optical amplifier structures could be substituted for it. The active region (113) forms a stripe of a given width and thickness which is imbedded in the laser chip and extends from facet (110) to the opposite facet (112). Typically, the laser or amplifier chip is 200μm wide and 300μm long. The active region (113) is 300μm long, 2μm wide, and about .2μm thick. A laser chip differs from an optical amplifier chip in that an optical amplifier chip usually has an anti-reflection coating on both facets (110) and (112) whereas a laser chip has the anti-reflection coating on one end only and that is the end (106) nearest the diffraction grating (105) in Figure 4B. The optical amplifier and semiconductor laser, according to the present invention, are manufactured in the same manner as prior-art optical amplifier and semiconductor lasers except for the fact that the active region is heavily n-doped when the active region is constructed from III-V materials. However, if a material system is used having a conduction band with a high density of states for electrons and a valence band with a low density of states for holes (the opposite of the situation for the III-V material), then the active layer (113) should be heavily p-doped.

Any one of the many narrow strip device structures can be utilized to implement the proposed invention. (For a summary of the various narrow strip device structures, see G.P. Agrawal and N.K. Dutta, Long Wavelength Semiconductor Lasers , Van Nostrand Reinhold Co., New York, 1986, Chapter 5.) As an example, the fabrication of one preferred structure, shown in Figure 4A, with a gain range centered at 1.3μm is described. On an n-doped InP substrate (115), in an initial epitaxial growth at least three layers (114), (113), and (117) of the InGaAsP composition system are grown. These layers (114, (113), and (117) and lattice matched to the substrate (115). The first layer (114) is an n-doped confining layer with a higher band gap then the active layer (113). The second layer (113) is the heavily n-doped active layer with a band gap corresponding to a wavelength of 1.3μm. The third layer (117) is a confining layer like (114) but p-doped. The strip (119) is photolithographically defined and a mesa stripe is etched. This etching process removes the unshielded area of layers (114), (113), and (117) and leaves the mesa structure. The mesa width determines the width of the active layer stripe. Next, in a second epitaxial growth, the etched out regions on the sides of the mesa stripe are filled in with a semiinsulating InP layer (121) and (123). Next, contacts are applied to the top and bottom of the wafer. Finally, chips (100) are cleaved from the wafer to a specified length which determines the length of the active layer stripe.

When the present invention is embodied to make a tunable laser, the semiconductor laser chip is placed in an external tuning cavity as shown in Figure 4B. The facet (106) with the anti-reflection coating faces a lens (103) that collimates the output of the laser chip (100) and a diffraction grating (105) which reflects light of a chosen wavelength (energy) back into the laser chip (100). This reflected light is reamplified in the laser chip (100). Some of this reamplified light will leave the external tuning cavity (101) through the exit facet (107) and the remainder will be further amplified. (For further discussion on external-cavity semiconductor lasers, see Olsson et al., "Performance Characteristics of 1.5μm External Cavity Semiconductor Lasers for Coherent Optical Communication", Journal of Lightwave Technology , Vol LT-5, No. 4 April 1987, pg. 510.) .

The distributed feedback losses of the external cavity (101), in Figure 4B, are represented by the loss curve (43) shown in Figure 2A. The semiconductor laser chip (100) in Figure 4B will lase in the external cavity (101) when the gain of the laser chip (100) exceeds the losses of the external cavity (101). Therefore, a laser chip (100) driven by an injection current, $I_3$, which corresponds to the gain curve (51), shown in Figure 2A, will lase in the external cavity (101) at energies lying between the points (53) and (59) where the gain and loss curves intersect. Likewise an injection current $I_2$, which corresponds to the gain curve (49), results in lasing at energies lying between intersection points (55) and (57). However, when the injection current is $I_1$, which corresponds to gain curve (47), lasing will occur only at a single energy (frequency) defined by the intersection point (61). The distributed feedback losses of the laser chip (100), represented by curve (45), depend on the anti-reflection coating (106). The lower the reflectivity of the coating, the higher the losses of the laser chip (100). The losses of the laser chip (100) should be as high as possible because its loss curve (45) limits the maximum height of the gain curves. If the laser chip (100) is driven with a current greater then $I_3$, the gain will not exceed the loss curve (45) and the system will lase at an energy defined by the intersection point (63).

A curve representing the tuning range of a semiconductor laser chip (100) inside the external tuning cavity (101) for various values of the injection current can be derived from Figure 2A as shown in Figure 2B. When the injection current equals $I_3$, the tuning range extends from (53) to (59). When the injection current equals $I_2$, the tuning range extends from (55) to (57). And when the injection current equals $I_1$ the laser lases only at (61). An increased gain bandwidth will clearly result in a wider tuning range.

When the present invention is applied as an optical amplifier, the amplifier chip (100) shown in Figures 4A and 4C will have an anti-reflective coating on both facets (110) and (112). The amplifier (100) is placed in the light path of the optical signal to be amplified. The light travels from the optical fiber (129) and is focused by the lens (125) onto the active layer (113) at the facet (110). The amplified light exits from facet (112) and is collected by lens (127) which focuses it onto another optical fiber. The light is amplified as long as the gain of the medium, as shown in Figure 2A, is larger than all losses which include the coupling losses from the fiber (129) to the amplifier (100) and from the device (100) to the fiber (131). These losses are purely transmission losses and are not distributed feedback losses. The gain and absorption curves of an optical amplifier are identical to these shown in Figure 2A for a laser chip. But, since the optical amplifier is not inside an external cavity, the meaning of the cavity-loss curve (43) must be changed from distributed feedback losses to distributed transmission losses. Therefore, no lasing occurs as the gain becomes higher than the losses. Lasing is not desired during operation of an amplifier. Lasing occurs when the gains exceed the chip losses given by the curve (45) in Figure 2B and the amplification regime is terminated.

The gain range of an optical amplifier at a given injection current covers an energy range where the gain exceeds the distributed transmission losses. If the optical amplifier is driven with an injection current $I_2$, the gain range extends from point (55) to point (57). Likewise, if the optical amplifier is driven with an injection current $I_3$, the gain range extends from point (53) to point (59). As described for the tunable laser, the optical bandwidth, which depends on the gain width, is higher for III-V optical amplifiers with high n-doping of the active layer (113).

## Claims

1. A semiconductor optical gain medium, comprising:
a conduction band;
a valence band; and
a means for increasing the gain bandwidth of the semiconductor optical gain medium by decreasing the effective band-gap energy between the conduction band and the valence band and by increasing the separation between the quasi-Fermi levels of the conduction band and the valence band through heavy doping of the gain medium.

2. A semiconductor optical gain medium, as in claim 1, wherein the semiconductor optical gain medium is fabricated from III-V materials and wherein the heavy doping of the gain medium is heavy n-doping.

3. A semiconductor optical gain medium, as in claim 2, wherein the means for increasing the gain bandwidth further comprises n-doping of the gain medium that exceeds a concentration of $1x10^{17} cm^{-3}$.

4. A semiconductor optical gain medium, as in claim 2, wherein the means for increasing the gain bandwidth further comprises n-doping of the gain medium that exceeds a concentration of $5x10^{17} cm^{-3}$.

5. A semiconductor optical gain medium, as in claim 1, wherein the semiconductor optical gain medium is fabricated from a material system having a conduction band with a high density of electron states and a valence band with a low density of hole states and wherein the heavy doping of the gain medium is heavy p-doping.

6. An optical amplifier having an active region, comprising:
a conduction band;
a valence band;
a means for increasing the bandwidth of the semiconductor optical amplifier by decreasing the effective band-gap energy between the conduction band and the valence band and by increasing the separation between the quasi-Fermi levels of the conduction band and the valence band through heavy doping of the active region; and
two parallel facets located at opposite ends of the optical amplifier through which optical signals enter and exit.

7. An optical amplifier, as in claim 6, wherein the optical amplifier is fabricated from a III-V material system and wherein the heavy doping of the active region is heavy n-doping.

8. An optical amplifier, as in claim 7, wherein the means for increasing the gain bandwidth further comprises an active region with n-doping that exceeds a concentration of $1x10^{17} cm^{-3}$.

9. An optical amplifier, as in claim 7, wherein the means for increasing the gain bandwidth further comprises an active region with n-doping that exceeds a concentration of $5x10^{17} cm^{-3}$.

10. An optical amplifier, as in claim 6, wherein the optical amplifier is fabricated from a material system having a conduction band with a high density of electron states and a valence band with a low density of hole states and wherein the heavy doping of the active region if heavy p-doping.

11. A tunable semiconductor laser having an active region, comprising:
a conduction band;
a valence band;
a means for increasing the tuning range of the semiconductor laser by decreasing the effective band gap energy between the conduction band and the valence band and by increasing the separation between the quasi-Fermi levels of the conduction band and the valence band through heavy doping of the active region; and
a means for tuning the output of the semiconductor laser.

12. A semiconductor laser, as in claim 11, wherein the semiconductor laser is fabricated from a III-V materials and wherein the heavy doping of the active region is heavy n-doping.

13. A semiconductor laser, as in claim 12, wherein the means for increasing the gain bandwidth further comprises an active region with n-doping that exceeds a concentration of $1x10^{17} cm^{-3}$.

14. A semiconductor laser, as in claim 12, wherein the means for increasing the gain bandwidth further comprises an active region with n-doping that exceeds a concentration of $5x10^{17} cm^{-3}$.

15. A semiconductor laser, as in claim 11, wherein the semiconductor laser is fabricated from a material system having a conduction band having a high density of electron states and a valence band having a low density of hole states and wherein heavy doping of the active region is heavy p-

doping.

**FIG 1**

FIG 2A

FIG 2B

FIG 3A

FIG 3B

FIG 4A

FIG 4B

FIG 4C